# EUROPÄISCHE PATENTSCHRIFT

(11) **EP 2 616 267 B1**
(45) Veröffentlichungstag und Bekanntmachung des Hinweises auf die Patenterteilung: **19.06.2019**
(21) Anmeldenummer: 11754846.1
(22) Anmeldetag: 09.08.2011
(51) Int. Cl.: B60L 11/18, G01R 31/36, H01M 10/48, H01M 10/0525, H02J 7/00

(54) **BATTERIE MIT ERFASSUNG VON ZELLSPANNUNGEN UND BATTERIESTROM UND NUR EINER POTENTIALTRENNUNGSEINRICHTUNG**
BATTERY HAVING CELL VOLTAGE AND BATTERY CURRENT DETECTION AND COMPRISING ONLY ONE ELECTRICAL ISOLATION DEVICE
BATTERIE À DÉTECTION DE TENSIONS D'ÉLÉMENTS ET DE COURANT DE BATTERIE COMPRENANT UN SEUL DISPOSITIF D'ISOLEMENT

(30) Priorität: 14.09.2010 DE 102010040713
(43) Veröffentlichungstag der Anmeldung: 24.07.2013
(73) Patentinhaber: Robert Bosch GmbH, 70442 Stuttgart (DE); SAMSUNG SDI CO., LTD., Yongin-si, Gyeonggi-do 446-577 (KR)
(72) Erfinder: HASENKOPF, Dirk, 70190 Stuttgart (DE); BUTZMANN, Stefan, 71717 Beilstein (DE)
(74) Vertreter: Bee, Joachim
(86) Internationale Anmeldenummer: PCT/EP2011/063688
(87) Internationale Veröffentlichungsnummer: WO 2012/034792

(56) Entgegenhaltungen:
- EP-A2- 1 933 443
- EP-A2- 1 967 861
- EP-A2- 2 224 257
- DE-A1-102009 000 336
- JP-A- 2001 025 173
- US-A- 5 773 958
- US-A- 5 773 958
- US-A1- 2008 100 266
- US-A1- 2008 238 432
- US-A1- 2010 060 295
- US-A1- 2010 185 405
- US-A1- 2010 213 891
- US-B1- 6 549 014
- US-B1- 6 664 764
- CHATZAKIS J ET AL: "Designing a new generalized battery management system", IEEE TRANSACTIONS ON INDUSTRIAL ELECTRONICS, IEEE SERVICE CENTER, PISCATAWAY, NJ, USA, Bd. 50, Nr. 5, 1. Oktober 2003 (2003-10-01), Seiten 990-999, XP011101942, ISSN: 0278-0046, DOI: 10.1109/TIE.2003.817706
- DURAN E ET AL: "Measurement method for PV modules based on DC-DC converters with microcontroller", 13TH EUROPEAN CONFERENCE ON POWER ELECTRONICS AND APPLICATIONS, 2009 : EPE '09 ; 8 - 10 SEPT. 2009, BARCELONA, SPAIN, IEEE, PISCATAWAY, NJ, USA, 8. September 2009 (2009-09-08), Seiten 1-10, XP031541368, ISBN: 978-1-4244-4432-8
- HANDE A ET AL: "A selective boost equalizer for series connected NiMH battery packs", POWER ELECTRONICS IN TRANSPORTATION, 2004 NOVI, MI, USA OCT. 21-22, 2004, PISCATAWAY, NJ, USA,IEEE, 21. Oktober 2004 (2004-10-21), Seiten 151-157, XP010770546, DOI: 10.1109/PET.2004.1393823 ISBN: 978-0-7803-8538-2
- WEBB D ET AL: "Measuring individual cell voltages in fuel cell stacks", JOURNAL OF POWER SOURCES, ELSEVIER SA, CH, Bd. 103, Nr. 1, 30. Dezember 2001 (2001-12-30), Seiten 54-60, XP004323996, ISSN: 0378-7753, DOI: 10.1016/S0378-7753(01)00831-X
- JIAN CAO ET AL: "Batteries Need Electronics", IEEE INDUSTRIAL ELECTRONICS MAGAZINE, IEEE, US, Bd. 5, Nr. 1, 1. März 2011 (2011-03-01), Seiten 27-35, XP011352364, ISSN: 1932-4529, DOI: 10.1109/MIE.2011.940251
- JUN-YOUNG LEE ET AL: "An Isolated DC/DC Converter Using High-Frequency Unregulated $LLC$ Resonant Converter for Fuel Cell Applications", IEEE TRANSACTIONS ON INDUSTRIAL ELECTRONICS, IEEE SERVICE CENTER, PISCATAWAY, NJ, USA, Bd. 58, Nr. 7, 1. Juli 2011 (2011-07-01), Seiten 2926-2934, XP011355885, ISSN: 0278-0046, DOI: 10.1109/TIE.2010.2076311

## Beschreibung

Die vorliegende Erfindung betrifft eine Batterie mit nur einer Potentialtrennungseinrichtung.

### Stand der Technik

Es zeichnet sich ab, dass in Zukunft sowohl bei stationären Anwendungen, als auch bei Fahrzeugen wie Hybrid- und Elektrofahrzeugen vermehrt Batteriesysteme zum Einsatz kommen werden. Um die für eine jeweilige Anwendung gegebenen Anforderungen an Spannung und zur Verfügung stellbare Leistung erfüllen zu können, werden eine hohe Zahl von Batteriezellen in Serie geschaltet. Da der von einer solchen Batterie bereitgestellte Strom durch alle Batteriezellen fließen muss und eine Batteriezelle nur einen begrenzten Strom leiten kann, werden oft zusätzlich Batteriezellen parallel geschaltet, um den maximalen Strom zu erhöhen. Dies kann entweder durch Vorsehen von mehreren Zellwickeln innerhalb eines Batteriezellengehäuses oder durch externes Verschalten von Batteriezellen geschehen.

Aus Sicherheitsgründen und zur Bestimmung des Ladezustandes der Batterie mit hinreichender Genauigkeit werden in solchen Batteriesystemen gewöhnlich verschiedene Messgrößen wie die Spannungen der einzelnen Batteriezellen (Zellspannungen), des Stromes durch die Batterie und die Temperatur ausgewählter oder aller Batteriezellen bestimmt. Diese Messgrößen werden von einer Steuereinheit (Battery Control Unit, BCU) erfasst, weiterverarbeitet und je nach Anwendung an andere Teile der Vorrichtung übermittelt.

Da die Batteriespannung eines solchen Batteriesystems hohe Werte erreichen kann, muss es aus Sicherheitsgründen isoliert von berührbaren Teilen der umgebenden Vorrichtung aufgebaut werden. Insbesondere bei Batteriesystemen, die in Kraftfahrzeugen als Traktionsbatterie eingesetzt werden, bedeutet das, dass das Batteriesystem isoliert gegen die Steuereinheit ausgeführt werden muss, weil diese an das Niederspannungsbordnetz angeschlossen ist und mit zahlreichen anderen Komponenten kommuniziert.

Eine Isolierung oder Potentialtrennung erzeugt jedoch technischen Mehraufwand und erhöht die Gesamtkosten der Anordnung. Daher ist es erstrebenswert, die Anzahl von Isolierungen oder Potentialtrennungen zu minimieren. Gemäß dem Stand der Technik wird abhängig von einer jeweils eingesetzten Halbleitertechnologie beziehungsweise deren Spannungsfestigkeit eine in der Hableitertechnologie ganz oder teilweise als Mikrochip gefertigten Zellspannungserfassungseinheit für eine Anzahl von Batteriezellen verwendet, für die die Summe der Zellspannungen die Spannungsfestigkeit der Zellspannungserfassungseinheit nicht überfordert. Die Batteriezellen werden dann mit der zugehörigen Zellspannungserfassungseinheit zu einem Batteriemodul zusammengefasst. Die einzelnen Zellspannungserfassungseinheiten sind dann über einen Kommunikationsbus zu einer Kette verschaltet, die über einen einzelnen Isolatorbaustein mit dem Mikrokontroller, der das Herz der Steuereinheit bildet, verbunden. Es besteht nun jedoch das Problem, dass auch die Messung des Batteriestromes unter Berücksichtigung der Sicherheitsbestimmungen erfolgen muss. Hierbei kann auf magnetfeldbasierte oder spannungsbasierte Methoden zur Strommessung zurückgegriffen werden. Die magnetfeldbasierte Strommessung ist prinzipbedingt einfach potentialgetrennt durchzuführen, ist aber für sich nur kostenintensiv zu realisieren. Die preisgünstige und einfache Messung durch die Messung einer Spannung an einem im Strompfad der Batterie angeordneten Widerstand bekannter Größe (Shunt-Prinzip) ist hingegen zwar preisgünstig zu realisieren, würde aber einen zusätzlichen Isolatorbaustein erfordern.

Soweit im Rahmen der Erfindung von einer Batterie gesprochen wird, kann auch ein Batteriezellstrang einer Batterie mit mehreren parallel geschalteten Batteriezellsträngen gemeint sein.

Die EP 1 933 443 A2 beschreibt ein Batteriezellenüberwachungssystem zum Überwachen einer Reihenschaltung von Batteriezellen mittels von Zellüberwachungseinheiten, die gemäß einer Daisy-Chain-Anordnung miteinander gekoppelt sind. Eine erste Zellüberwachungseinheit und eine letzte Zellüberwachungseinheit sind jeweils mit einem ersten Optokopplerüber für eingehende Signale bzw. mit einem zweiten Optokoppler für ausgehende Signale gekoppelt, über welche eine Kommunikation mit einer galvanisch getrennten Batteriemanagementeinheit ermöglicht wird. Der erste Optokoppler ist ferner über ein zur einer ersten Batteriezelle parallel geschaltetes, als Pull-Up-Widerstand fungierendes Widerstandselement mit der Reihenschaltung von Batteriezellen verbunden.

Die US 2010/0213891 beschreibt einen im Strompfad der Batterie geschalteten Messwiderstand. Es beschreibt außerdem einen Verstärker, der zwischen den Widerstand und eine Spannungsmesseinrichtung geschaltet ist.

### Offenbarung der Erfindung

Erfindungsgemäß wird daher eine Batterie mit den Merkmalen gemäß dem unabhängigen Anspruch 1 bereitgestellt. Die erfindungsgemäße Batterie weist insbesondere eine Mehrzahl von zwischen einen Pluspol und einen Minuspol in Serie geschalteten Batteriezellen und eine Mehrzahl von Zellspannungserfassungseinheiten auf. Die Zellspannungserfassungseinheiten besitzen jeweils eine Mehrzahl von mit einer Gruppe der Batteriezellen verbundenen Spannungsmesseingängen und sind ausgebildet, Zellspannungen der mit der jeweiligen Zellspannungserfassungseinheit verbundenen Batteriezellen zu bestimmen. Die Zellspannungserfassungseinheiten sind miteinander durch einen Kommunikationsbus verbunden und außerdem ausgebildet, die bestimmten Zellspannungen über den Kommunikationsbus an einen durch eine Potentialtrennungsvorrichtung galvanisch von den Zellspannungserfassungseinheiten abgekoppelten Mikrocontroller zu übermitteln. Erfindungsgemäß weist die Batterie zur Strommessung einen im Strompfad der Batterie angeordneten, mit den Batteriezellen in Serie geschalteten Widerstand auf. Wenigstens ein erster Anschluss des Widerstandes ist mit einem ausgewählten Spannungsmesseingang einer der Zellspannungserfassungseinheiten verbunden.

Die Erfindung bietet den Vorteil, dass nur ein Isolatorbaustein für die Messung sowohl der Zellspannungen als auch des die Batterie durchfließenden Stromes benötigt wird und dennoch die kostengünstige indirekte Messung des Stromes durch Messung der Spannung an einem Widerstand bekannter Größe verwendet werden kann. Die Strommessung wird hierfür über eine der Zellspannungserfassungseinheiten realisiert, so dass ohne Mehraufwand für die Isolierung/Potentialtrennung ein, den durch die Batterie fließenden Strom, repräsentierender Messwert wie eine Zellspannung und zusammen mit den Zellspannungen der Batteriezellen an den Mikrocontroller übermittelt werden kann. Außerdem ist vorteilhaft, dass dieser Strommesswert synchron mit den Zellspannungen bestimmt wird, weil für die Messung der Zellspannungen und des Strommesswertes derselbe Baustein verwendet wird.

Erfindungsgemäß verfügt die Batterie über einen Verstärker, der zwischen den Widerstand und den ausgewählten Spannungsmesseingang der einen der Zellspannungserfassungseinheiten geschaltet und ausgebildet ist, um eine über dem Widerstand anliegende Spannung zu verstärken. Durch Verwendung des Verstärkers wird es möglich, einen Widerstand mit einem sehr geringen Widerstandswert für die Strommessung zu verwenden, da die an diesem Widerstand abfallende, entsprechend geringe Spannung für die Erfassung durch die Zellspannungserfassungseinheit verstärkt wird. Dies ist deshalb vorteilhaft, weil der Innenwiderstand der Batterie durch den Widerstand nur geringfügig erhöht wird und durch den Widerstand aufgrund seines geringen Widerstandswertes entsprechend wenig Verlustleistung und -wärme erzeugt wird.

Ein Verstärkungsfaktor des Verstärkers wird erfindungsgemäß derartig vorgegeben sein, dass ein maximal zulässiger Strom der Batterie eine Ausgangsspannung des Verstärkers bewirkt, welche kleiner als eine maximal zulässige Eingangsspannung der Spannungsmesseingänge der einen Zellspannungserfassungseinheit ist. Hierdurch wird sichergestellt, dass die Zellspannungserfassungseinheit den Strom der Batterie über den gesamten relevanten Messbereich erfassen und auch ein Überschreiten des maximal zulässigen Batteriestromes feststellen kann.

Dabei ist der Verstärkungsfaktor des Verstärkers bevorzugt derartig vorgegeben, dass ein maximal zulässiger Strom der Batterie eine Ausgangsspannung des Verstärkers bewirkt, welche außerdem kleiner als eine maximal zulässige Zellspannung der Batteriezellen oder gleich der maximal zulässigen Zellspannung der Batteriezellen ist. Diese Ausführungsform der Erfindung besitzt den Vorteil, dass die maximale Spannung, die für die Strommessung von der Zellspannungserfassungseinheit verarbeitet werden muss, einer maximal zulässigen Zellspannung entspricht, so dass gleiche Verarbeitungswege für sowohl Zellspannungen als auch den Strommesswert verwendet werden können.

Bevorzugt weist der Verstärker einen ersten Versorgungsspannungsanschluss für eine untere Versorgungsspannung und einen zweiten Versorgungsspannungsanschluss für eine obere Versorgungsspannung auf. Dabei sind der erste Versorgungsspannungsanschluss mit einer ersten Batteriezelle der mit der einen Zellspannungserfassungseinheit verbundenen Batteriezellen und der zweite Versorgungsspannungsanschluss mit einer zweiten Batteriezelle der mit der einen Zellspannungserfassungseinheit verbundenen Batteriezellen verbunden.

In einer ersten Ausführungsform sind dabei der erste Versorgungsspannungsanschluss direkt mit der ersten Batteriezelle der mit der einen Zellspannungserfassungseinheit verbundenen Batteriezellen und der zweite Versorgungsspannungsanschluss direkt mit der zweiten Batteriezelle der mit der einen Zellspannungserfassungseinheit verbundenen Batteriezellen verbunden, so dass der Verstärker direkt aus den Batteriezellen versorgt wird.

In einer alternativen Ausführungsform ist ein DC/DC-Umsetzer vorgesehen, der den ersten Versorgungsspannungsanschluss mit der ersten Batteriezelle der mit der einen Zellspannungserfassungseinheit verbundenen Batteriezellen und den zweiten Versorgungsspannungsanschluss mit der zweiten Batteriezelle der mit der einen Zellspannungserfassungseinheit verbundenen Batteriezellen verbindet und ausgebildet ist, die obere Versorgungsspannung und die untere Versorgungsspannung zu erzeugen und an den Verstärker auszugeben. Der DC/DC-Umsetzer bietet den Vorteil, eine Versorgungsspannung zu erzeugen, die unabhängig beispielsweise von einem Ladezustand der Batteriezellen ist.

Die Batterie kann m Zellspannungserfassungseinheiten aufweisen, wobei jede der Zellspannungserfassungseinheiten n Spannungsmesseingänge umfasst und die Batterie m*n-1 in Serie geschaltete Batteriezellen besitzt. Bei dieser Ausführungsvariante werden vorteilhaft nur identisch aufgebaute Zellspannungserfassungseinheiten verwendet, wobei an einer der Zellspannungserfassungseinheiten eine Batteriezelle weniger angeschlossen wird als an die verbleibenden, und der freibleibende Spannungsmesseingang für die Strommessung verwendet wird. Die Verwendung identisch aufgebauter Komponenten erlaubt eine rationellere und somit kostengünstigere Produktion.

Alternativ kann die Batterie m Zellspannungserfassungseinheiten aufweisen, wobei jede der Zellspannungserfassungseinheiten n Spannungsmesseingänge umfasst und die Batterie m*n-m in Serie geschaltete Batteriezellen besitzt. In diesem Fall werden an alle Zellspannungserfassungseinheiten gleich viele Batteriezellen angeschlossen, so dass bei jeder Zellspannungserfassungseinheit ein Spannungsmesseingang frei bleibt und sich identische Batteriemodule, jeweils mit einer Zellspannungserfassungseinheit und n-1 Batteriezellen umfassend, ergeben. Bei einer der Zellspannungserfassungseinheiten wird dieser Spannungsmesseingang dann für die Strommessung eingesetzt. Bei dieser Ausführungsform bietet sich der Vorteil, dass identisch aufgebaute Batteriemodule verwendet werden und nur bei einem Batteriemodul eine zusätzliche Kontaktierung für die Strommessung vorgenommen werden muss.

Die Batterie weist besonders bevorzugt Lithium-Ionen-Batteriezellen auf, welche aufgrund ihrer hohen Zellspannung und des günstigen Verhältnisses zwischen Volumen und maximaler gespeicherter Energie besonders geeignet sind.

Ein zweiter Erfindungsaspekt führt ein Kraftfahrzeug mit einem elektrischen Antriebsmotor zum Antreiben des Kraftfahrzeuges und einer mit dem Antriebsmotor verbundenen Batterie gemäß dem ersten Erfindungsaspekt ein.

### Zeichnungen

Ausführungsbeispiele der Erfindung werden anhand der Zeichnungen und der nachfolgenden Beschreibung näher erläutert. Es zeigen:
- Figur 1: ein Batteriesystem gemäß dem Stand der Technik,
- Figur 2: ein weiteres Batteriesystem gemäß dem Stand der Technik und
- Figur 3: ein Ausführungsbeispiel der Erfindung.

### Ausführungsformen der Erfindung

In den Figuren bedeuten gleiche Bezugszeichen gleiche oder gleichartige Funktionseinheiten. Sofern nichts Abweichendes beschrieben ist, gilt daher das für die anderen Figuren Gesagte entsprechend.

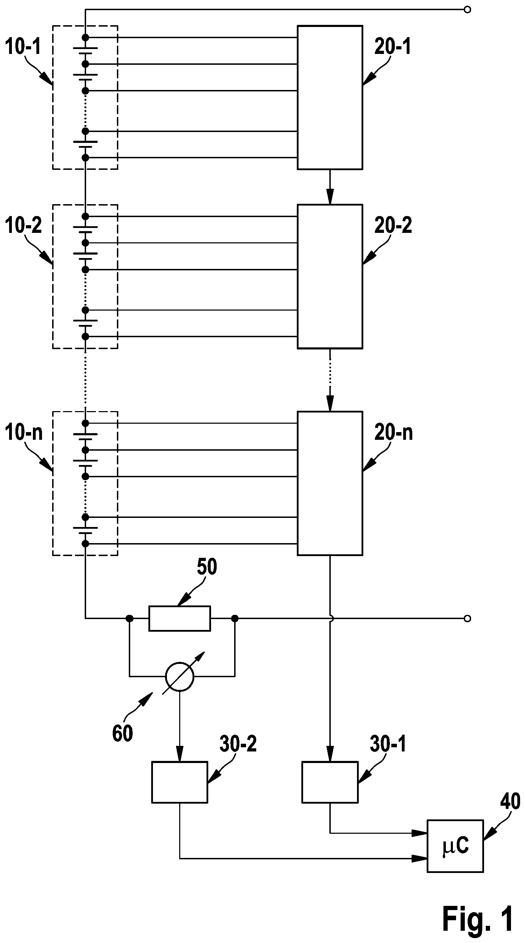

Figur 1 zeigt ein Batteriesystem gemäß dem Stand der Technik. Eine Vielzahl von Batteriezellen ist zwischen einen Pluspol und einen Minuspol in Serie geschaltet, so dass sich ein Batteriezellstrang ergibt. Das gezeigte Beispiel besitzt einen Batteriezellstrang. Es können aber auch mehrere, solche Batteriezellstränge parallel geschaltet werden, um die zur Verfügung stellbare Leistung und die Kapazität des Batteriesystems zu erhöhen. Die Batteriezellen sind in Gruppen 10-1 bis 10-n unterteilt, die vorzugsweise jeweils dieselbe Anzahl Batteriezellen enthalten. Allerdings können die Gruppen von Batteriezellen auch unterschiedliche Zahlen von Batteriezellen aufweisen. Jede Gruppe von Batteriezellen 10-1 bis 10-n ist mit einer zugeordneten Zellspannungserfassungseinheit 20-1 bis 20-n verbunden, welche ausgebildet sind, die Zellspannungen der Batteriezellen zu erfassen. Außerdem können die Zellspannungserfassungseinheiten 20-1 bis 20-n ausgebildet sein, weitere Betriebsparameter wie beispielsweise die Temperatur einer oder aller Batteriezellen zu bestimmen. Die Zellspannungserfassungseinheiten 20-1 bis 20-n sind untereinander durch einen Kommunikationsbus verbunden, welcher über einen Isolatorbaustein 30-1 (Potentialtrennungsvorrichtung) mit einem Mikrocontroller 40 eine Battery Control Unit (BCU) verbunden ist. Die Zellspannungserfassungseinheiten 20-1 bis 20-n übermitteln die erfassten Zellspannungen der Batteriezellen über den Kommunikationsbus und den Isolatorbaustein 30-1 an den Mikrocontroller 40, welcher anhand dieser Daten beispielsweise Ladezustände der Batteriezellen und andere Parameter des Batteriesystems bestimmen kann. Aufgrund der Verschaltung der Zellspannungserfassungseinheiten 20-1 bis 20-n über den Kommunikationsbus wird trotz der gegebenenfalls hohen Anzahl von Zellspannungserfassungseinheiten 20-1 bis 20-n nur ein Isolatorbaustein 30-1 benötigt, um alle Zellspannungen an den Mikrocontroller 40 zu übermitteln.

Als weiterer wichtiger Betriebsparameter soll in einem Batteriesystem gewöhnlich der Batteriestrom bestimmt werden. Hierfür kann ein in den Strompfad geschalteter Widerstand 50 vorgesehen sein, der einen bekannten und möglichst niedrigen Widerstandswert aufweist. Mit einer Spannungsmesseinheit 60 wird dann die Spannung über dem Widerstand 50 gemessen, was einen direkten Rückschluss auf den fließenden Strom zulässt. Der von der Spannungsmesseinheit 60 gemessene Wert muss jedoch über einen weiteren Isolatorbaustein 30-2 an den Mikrocontroller 40 übermittelt werden, weil die Spannungsmesseinheit 60 in leitendem Kontakt mit der Batterie steht, so dass im Fehlerfall aufgrund der hohen Batteriespannung ein Sicherheitsrisiko bestünde.

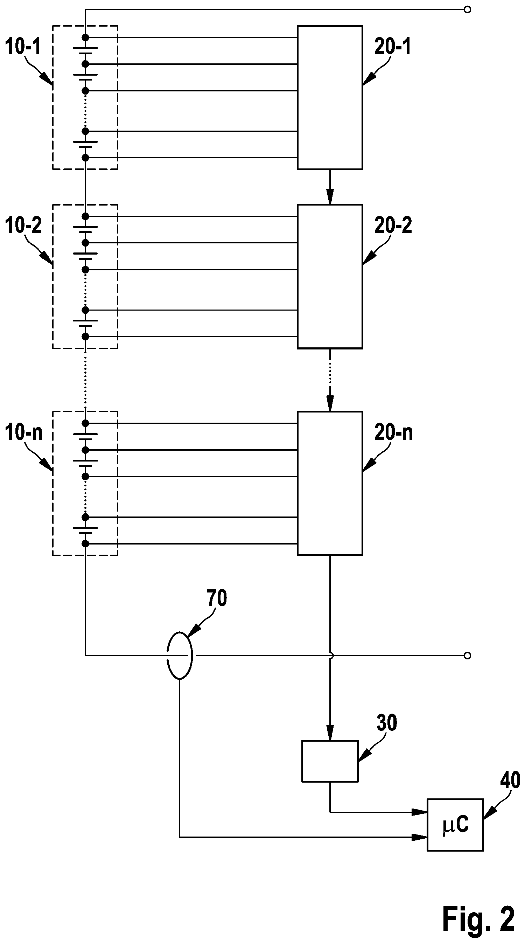

Figur 2 zeigt ein weiteres Batteriesystem gemäß dem Stand der Technik. Im Unterschied zu dem Beispiel von Figur 1 wird ein Magnetfeldsensor 70, beispielsweise eine Hall-Sonde, zur Messung des Stromes verwendet. Da ein solcher Magnetfeldsensor 70 den fließenden Strom indirekt über das den stromführenden Leiter umgebende Magnetfeld misst, kann er leicht so konstruiert werden, dass er die unter Hochspannung stehenden Teile des Batteriesystems nicht berührt und so den Sicherheitsbestimmungen genüge getan wird. Daher kann der Magnetfeldsensor 70 direkt, also ohne einen zweiten Isolatorbaustein, an den Mikrocontroller 40 angebunden werden. Trotz der Einsparung des teuren zweiten Isolatorbausteins des Beispiels der Figur 1 hat diese Ausführung jedoch den Nachteil, dass ein Magnetfeldsensor gegenüber der Strommessung über einen Widerstand wie in Figur 1 gezeigt nur sehr teuer zu realisieren ist.

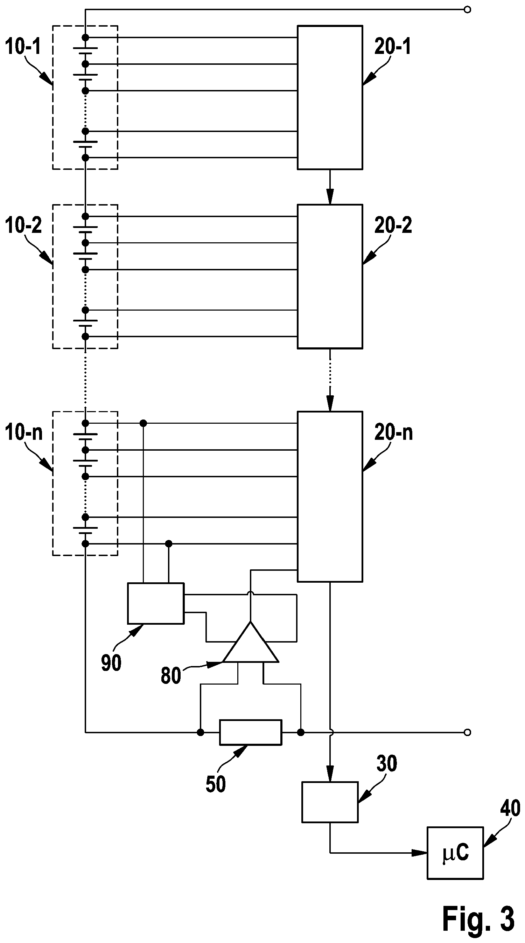

Figur 3 zeigt ein Ausführungsbeispiel der Erfindung. Erfindungsgemäß wird ein Widerstand 50 zur Messung des Batteriestromes in den Strompfad geschaltet. Optional kann ein Verstärker 80 vorgesehen sein, der die Spannung über den Widerstand 50 auf einen geeigneten Wertebereich verstärkt. Der Verstärker 80 kann direkt von den Batteriezellen einer Gruppe von Batteriezellen versorgt werden, also direkt mit den Batteriezellen verbundene Versorgungsleitungen aufweisen, oder aber - wie in Figur 3 gezeigt - über einen DC/DC-Umsetzer 90, der zwischen den Verstärker 80 und die Batteriezellen geschaltet ist. In diesem Fall ist der Verstärker 80 indirekt mit den Batteriezellen verbunden.

Der DC/DC-Umsetzer 90 hat die Aufgabe, eine von den Ladezuständen und somit den Zellspannungen der Batteriezellen unabhängige und stabile Versorgungsspannung für den Verstärker 80 zu erzeugen. Der Ausgang des Verstärkers (oder bei Ausführungen der Erfindung ohne Verstärker 80 wenigstens ein Anschluss des Widerstandes 50) ist erfindungsgemäß mit einem Spannungsmesseingang einer der Zellspannungserfassungseinheiten 20-1 bis 20-n, im gezeigten Beispiel der Zellspannungserfassungseinheit 20-b, verbunden. Die Zellspannungserfassungseinheit 20-n erfasst die Ausgangsspannung des Verstärkers 80 in ähnlicher oder identischer Weise wie die Zellspannungen der Batteriezellen und übermittelt die derart erfasste Ausgangsspannung des Verstärkers 80 zusammen mit den erfassten Zellspannungen über den Kommunikationsbus und den Isolatorbaustein 30 an den Mikrocontroller 40 der BCU. Die Erfindung ermöglicht es so, nur einen Isolatorbaustein 30 vorzusehen und dennoch die kostengünstigere Strommessmethode zu verwenden, ohne die geltenden Sicherheitsbestimmungen zu verletzen. Die Zellspannungserfassungseinheit 20-n kann dazu gegenüber den anderen Zellspannungserfassungseinheiten einen zusätzlichen Spannungsmesseingang aufweisen. Bevorzugt sind jedoch alle Zellspannungserfassungseinheiten 20-1 bis 20-n identisch aufgebaut. Dies bedeutet, dass entweder ein Spannungsmesseingang der weiteren Zellspannungserfassungseinheiten ungenutzt bleibt, oder aber die Gruppe von Batteriezellen, die mit der Zellspannungserfassungseinheit 20-n verbunden ist, eine Batteriezelle weniger aufweist als die anderen Gruppen von Batteriezellen.

Die Erfindung erlaubt vorteilhaft den Einsatz bereits existierender Zellspannungserfassungseinheiten, welche als ICs in großen Stückzahlen produziert werden.

## Patentansprüche

1. Eine Batterie mit einer Mehrzahl von zwischen einen Pluspol und einen Minuspol in Serie geschalteten Batteriezellen und einer Mehrzahl von Zellspannungserfassungseinheiten (20-1, ..., 20-n), die eine Mehrzahl von jeweils mit einer Gruppe der Batteriezellen (10-1, ..., 10-n) verbundenen Spannungsmesseingängen aufweisen und ausgebildet sind, Zellspannungen der mit der jeweiligen Zellspannungserfassungseinheit (20-1, ..., 20-n) verbundenen Batteriezellen zu bestimmen, wobei die Zellspannungserfassungseinheiten (20-1, ..., 20-n) miteinander durch einen Kommunikationsbus verbunden und außerdem ausgebildet sind, die bestimmten Zellspannungen über den Kommunikationsbus an einen durch eine Potentialtrennungsvorrichtung (30) galvanisch von den Zellspannungserfassungseinheiten (20-1, ..., 20-n) abgekoppelten Mikrocontroller (40) zu übermitteln, **dadurch gekennzeichnet, dass** die Batterie einen im Strompfad der Batterie angeordneten, mit den Batteriezellen in Serie geschalteten Widerstand (50) zur Strommessung aufweist, wobei wenigstens ein erster Anschluss des Widerstandes (50) mit einem ausgewählten Spannungsmesseingang einer der Zellspannungserfassungseinheiten (20-1, ..., 20-n) verbunden ist, und die Batterie einen Verstärker (80) aufweist, der zwischen den Widerstand (50) und den ausgewählten Spannungsmesseingang der einen der Zellspannungserfassungseinheiten (20-1, ..., 20-n) geschaltet und ausgebildet ist, eine über dem Widerstand (50) anliegende Spannung zu verstärken, wobei ein Verstärkungsfaktor des Verstärkers (80) derartig vorgegeben ist, dass ein maximal zulässiger Strom der Batterie eine Ausgangsspannung des Verstärkers (80) bewirkt, welche kleiner als eine maximal zulässige Eingangsspannung der Spannungsmesseingänge der einen Zellspannungserfassungseinheit (20-n) ist.

2. Die Batterie gemäß Anspruch 1, bei der der Verstärkungsfaktor des Verstärkers (80) derartig vorgegeben ist, dass ein maximal zulässiger Strom der Batterie eine Ausgangsspannung des Verstärkers (80) bewirkt, welche außerdem kleiner als eine maximal zulässige Zellspannung der Batteriezellen oder gleich der maximal zulässigen Zellspannung der Batteriezellen ist.

3. Die Batterie gemäß einem der Ansprüche 1 oder 2, bei der der Verstärker (80) einen ersten Versorgungsspannungsanschluss für eine untere Versorgungsspannung und einen zweiten Versorgungsspannungsanschluss für eine obere Versorgungsspannung aufweist, wobei der erste Versorgungsspannungsanschluss mit einer ersten Batteriezelle der mit der einen Zellspannungserfassungseinheit (20-n) verbundenen Batteriezellen und der zweite Versorgungsspannungsanschluss mit einer zweiten Batteriezelle der mit der einen Zellspannungserfassungseinheit (20-n) verbundenen Batteriezellen verbunden sind.

4. Die Batterie gemäß Anspruch 3, bei der der erste Versorgungsspannungsanschluss direkt mit der ersten Batteriezelle der mit der einen Zellspannungserfassungseinheit (20-n) verbundenen Batteriezellen und der zweite Versorgungsspannungsanschluss direkt mit der zweiten Batteriezelle der mit der einen Zellspannungserfassungseinheit (20-n) verbundenen Batteriezellen verbunden sind.

5. Die Batterie gemäß Anspruch 3, mit einem DC/DC-Umsetzer (90), welcher den ersten Versorgungsspannungsanschluss mit der ersten Batteriezelle der mit der einen Zellspannungserfassungseinheit (20-n) verbundenen Batteriezellen und den zweiten Versorgungsspannungsanschluss mit der zweiten Batteriezelle der mit der einen Zellspannungserfassungseinheit (20-n) verbundenen Batteriezellen verbindet und ausgebildet ist, die obere Versorgungsspannung und die untere Versorgungsspannung zu erzeugen und an den Verstärker (80) auszugeben.

6. Die Batterie gemäß einem der vorhergehenden Ansprüche, die m Zellspannungserfassungseinheiten (20-1, ..., 20-n) aufweist und bei der jede der Zellspannungserfassungseinheiten (20-1, ..., 20-n) n+1 Spannungsmesseingänge umfasst, wobei die Batterie m*n-1 in Serie geschaltete Batteriezellen besitzt.

7. Die Batterie gemäß einem der Ansprüche 1 bis 3, die m Zellspannungserfassungseinheiten (20-1, ..., 20-n) aufweist und bei der jede der Zellspannungserfassungseinheiten (20-1, ..., 20-n) n+1 Spannungsmesseingänge umfasst, wobei die Batterie m*n-m in Serie geschaltete Batteriezellen besitzt.

8. Ein Kraftfahrzeug mit einem elektrischen Antriebsmotor zum Antreiben des Kraftfahrzeuges und einer mit dem Antriebsmotor verbundenen Batterie gemäß einem der vorhergehenden Ansprüche.

## Claims

1. Battery comprising a plurality of battery cells connected in series between a positive terminal and negative terminal and a plurality of cell voltage detection units (20-1, ..., 20-n), which have a plurality of voltage measurement inputs connected in each case to a group of battery cells (10-1, ..., 10-n) and are designed to determine cell voltages of the battery cells connected to the respective cell voltage detection unit (20-1, ..., 20-n), wherein the cell voltage detection units (20-1, ..., 20-n) are connected to one another by a communications bus and are moreover designed to communicate the determined cell voltages via the communications bus to a microcontroller (40), which is DC-decoupled from the cell voltage detection units (20-1, ... , 20-n) by an electrical isolation apparatus (30), **characterized in that** the battery has a resistor (50) for current measurement which is arranged in the current path of the battery and connected in series with the battery cells, wherein at least one first connection of the resistor (50) is connected to a selected voltage measurement input of one of the cell voltage detection units (20-1, ...,20-n), and the battery has an amplifier (80), which is connected between the resistor (50) and the selected voltage measurement input of said one of the cell voltage detection units (20-1, ..., 20-n) and is designed to amplify a voltage present across the resistor (50), wherein a gain factor of the amplifier (80) is predetermined such that a maximum permissible current of the battery effects an output voltage of the amplifier (80), which is lower than a maximum permissible input voltage of the voltage measurement inputs of said one cell voltage detection unit (20-n).

2. Battery according to Claim 1, in which the gain factor of the amplifier (80) is predetermined in such a way that a maximum permissible current of the battery effects an output voltage of the amplifier (80), which is also lower than a maximum permissible cell voltage of the battery cells or equal to the maximum permissible cell voltage of the battery cells.

3. Battery according to either of Claims 1 and 2, in which the amplifier (80) has a first supply voltage connection for a lower supply voltage and a second supply voltage connection for an upper supply voltage, wherein the first supply voltage connection is connected to a first battery cell of the battery cells connected to said one cell voltage detection unit (20-n) and the second supply voltage connection is connected to a second battery cell of the battery cells connected to said one cell voltage detection unit (20-n).

4. Battery according to Claim 3, in which the first supply voltage connection is connected directly to the first battery cell of the battery cells connected to said one cell voltage detection unit (20-n) and the second supply voltage connection is connected directly to the second battery cell of the battery cells connected to said one cell voltage detection unit (20-n).

5. Battery according to Claim 3, comprising a DC-to-DC converter (90), which connects the first supply voltage connection to the first battery cell of the battery cells connected to said one cell voltage detection unit (20-n) and the second supply voltage connection to the second battery cell of the battery cells connected to said one cell voltage detection unit (20-n) and is designed to generate the upper supply voltage and the lower supply voltage and to output said voltages to the amplifier (80).

6. Battery according to one of the preceding claims, said battery having m cell voltage detection units (20-1, ..., 20-n), and in which battery each of the cell voltage detection units (20-1, ..., 20-n) comprises n+1 voltage measurement inputs, wherein the battery has m*n-1 battery cells connected in series.

7. Battery according to one of Claims 1 to 3, which battery has m cell voltage detection units (20-1, ..., 20-n) and in which battery each of the cell voltage detection units (20-1, ..., 20-n) comprises n+1 voltage measurement inputs, wherein the battery has m*n-m battery cells connected in series.

8. Motor vehicle with an electric drive motor for driving the motor vehicle and a battery according to one of the preceding claims connected to the drive motor.

## Revendications

1. Batterie comprenant une pluralité d'éléments de batterie connectés en série entre un pôle positif et un pôle négatif, et une pluralité d'unités de détection de tension d'élément (20-1, ...., 20-n) qui présentent respectivement une pluralité d'entrées de mesure de tension reliées à un groupe des éléments de batterie (10-1,...,.., 10-n) et qui sont conçues pour déterminer des tensions des éléments de batterie reliés à l'unité de détection de tension d'élément (20-1, ..., 20-n), dans laquelle les unités de détection de tension d'élément (20-1, ...., 20-n) sont reliées les unes aux autres par un bus de communication et sont en outre conçues pour transmettre, par l'intermédiaire du bus de communication, les tensions d'éléments déterminées à un microcontrôleur (40) qui est isolé galvaniquement des unités de détection de tension d'élément (20-1,..., 20-n) par un dispositif d'isolement de potentiel (30), **caractérisée en ce que** la batterie comporte une résistance (50) montée en série avec les éléments de batterie et disposée sur le trajet de courant de la batterie, à des fins de mesure de tension, dans laquelle au moins une première borne de la résistance (50) est reliée à une entrée de mesure de tension sélectionnée de l'une des unités de détection de tension d'élément (20-1, ...., 20-n), et la batterie comporte un amplificateur (80) qui est monté entre la résistance (50) et l'entrée de mesure de tension sélectionnée de ladite une des unités de détection de tension d'élément (20-1, ..., 20-n) et qui est conçu pour amplifier une tension aux bornes de la résistance (50), dans laquelle un facteur de gain de l'amplificateur (80) est prédéterminé de manière à ce qu'un courant maximal admissible de la batterie provoque une tension de sortie de l'amplificateur (80) qui est inférieure à une tension d'entrée maximale admissible des entrées de mesure de tension de l'unité de détection de tension d'élément (20-n) .

2. Batterie selon la revendication 1, dans laquelle le facteur de gain de l'amplificateur (80) est prédéterminé de manière à ce qu'un courant maximal admissible de la batterie provoque une tension de sortie de l'amplificateur (80) qui est en outre inférieure à une tension d'élément maximale admissible des éléments de batterie ou qui est égale à la tension d'élément maximale admissible des éléments de batterie.

3. Batterie selon l'une des revendications 1 ou 2, dans laquelle l'amplificateur (80) présente une première borne de tension d'alimentation pour une tension d'alimentation inférieure et une seconde borne de tension d'alimentation pour une tension d'alimentation supérieure, dans laquelle la première borne de tension d'alimentation est reliée à un premier élément de batterie des éléments de batterie reliés à ladite une unité de détection de tension d'élément (20-n) et la seconde borne de tension d'alimentation est reliée à un second élément de batterie des éléments de batterie reliés à ladite une unité de détection de tension d'élément (20-n).

4. Batterie selon la revendication 3, dans laquelle la première borne de tension d'alimentation est directement reliée au premier élément de batterie des éléments de batterie reliés à l'unité de détection de tension d'élément (20-n) et la seconde borne de tension d'alimentation est directement reliée au second élément de batterie des éléments de batterie reliés à l'unité de détection de tension d'élément (20-n).

5. Batterie selon la revendication 3, comportant un convertisseur DC/DC (90) qui relie la première borne de tension d'alimentation au premier élément de batterie des éléments de batterie reliés à l'unité de détection de tension d'élément (20-n) et la seconde borne de tension d'alimentation au second élément de batterie des éléments de batterie reliés à l'unité de détection de tension d'élément (20-n) et qui est conçu pour générer la tension d'alimentation supérieure et la tension d'alimentation inférieure et pour les délivrer à l'amplificateur (80).

6. Batterie selon l'une des revendications précédentes, qui comporte m unités de détection de tension d'élément (20-1, ...., 20-n) et dans laquelle chacune des unités de détection de tension d'éléments (20-1, ...., 20-n) comprend n+1 entrées de mesure de tension, dans laquelle la batterie possède m*n-1 éléments de batterie montés en série.

7. Batterie selon l'une des revendications 1 à 3, qui comporte m unités de détection de tension d'élément (20-1, ...., 20-n) et dans laquelle chacune des unités de détection de tension d'élément (20-1, ...., 20-n) comprend n+1 entrées de mesure de tension, dans laquelle la batterie possède m*n-m éléments de batterie montés en série.

8. Véhicule automobile comportant un moteur d'entraînement électrique pour l'entraînement du véhicule automobile et une batterie selon l'une des revendications précédentes qui est reliée au moteur d'entraînement.
